Europäisches Patentamt

European Patent Office

Office européen des brevets

(11) Publication number: **0 361 121**
**A2**

## (12) EUROPEAN PATENT APPLICATION

(21) Application number: **89116101.0**

(22) Date of filing: **31.08.89**

(51) Int. Cl.5 **H01L 21/76 , H01L 29/06**

(30) Priority: **31.08.88 JP 216821/88**

(43) Date of publication of application:
**04.04.90 Bulletin 90/14**

(84) Designated Contracting States:
**DE FR GB NL**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Hatano, Hiroshi c/o Intellectual**
**Property Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor IC device with improved element isolating scheme.**

(57) A parasitic MOS transistor (Q2) set in normally-OFF state is used as an element isolating region of a semiconductor IC device. This parasitic MOS transistor (Q2) is formed in such a way that a first oxide film (2) formed on a P type semiconductor substrate (1) serves as a gate insulative film, a polycrystalline silicon layer (3) formed on the oxide film (2) serves as a gate electrode, and N type impurity regions (6, 7) formed in a surface region of the semiconductor substrate (1) on both sides of the polycrystalline silicon layer (3) respectively serve as source and drain regions. A second oxide film (4) is formed on the surface of the polycrystalline silicon layer (3), which is applied with a ground potential.

FIG. 1B

## Semiconductor IC device with improved element isolating scheme

The present invention relates to a semiconductor IC device, and more particularly, to a technique for isolating elements from one another in an MOS IC.

Selective oxidization by the LOCOS (Local Oxidation Of Silicon) method is known as a typical device isolating technique for use in an MOS LSI. As well known, however, a field oxide film formed by this LOCOS method is likely to have bird's beaks, thus making it difficult to finer patterning and hindering higher integration. In addition, if an MOS transistor is formed in an element region which is formed by separating the surface of a semiconductor substrate by means of a thick field oxide film provided by the LOCOS method, the following problems would arise.

When radiation such as gamma rays is irradiated on an MOS transistor, stationary positive charges are accumulated in an oxide film and a surface state is created. The stationary positive charges and the surface state shift the threshold voltage of the MOS transistor to the negative direction, and reduce the channel mobility of carriers. This phenomenon is described in IEEE Trans. Nucl. Sci., NS-25, No. 6, 1978, page 1216 by R. Freeman et al. More specifically, irradiation of radiation reduces the threshold voltage of an N channel type MOS transistor and further reduces the threshold voltage of a P channel type MOS transistor. To overcome this problem, efforts have been made to suppress a change in element parameters by lowering the process temperature (refer to page 70 in Solid State Technology, 1979, by G. W. Hughes et al.).

The amount of the threshold voltage shifted by the radiation is proportional to the square to cube of the thickness of the oxide film (refer to IEEE Trans. Nucl. Sci. NS-22, No. 6, 1975, page 2151 by G. F. Derbenwick et al.). In a parasitic MOS transistor formed under a thick field oxide film, therefore, the threshold voltage would significantly vary by the irradiated radiation. This causes the parasitic MOS transistor to be normally turned ON under the atmosphere where radiation is irradiated. A field leak current is therefore generated, disabling the element isolation.

Accordingly, it is the primary object of this invention to provide a semiconductor IC device which ensures formation of narrower element isolating regions and thus realizes higher integration.

It is another object of this invention to provide a semiconductor IC device which can prevent a parasitic MOS transistor from being turned ON even under the atmosphere of radiation in order to prevent generation of a field leak current.

The first object is achieved by a semiconductor IC device which comprises:

a semiconductor substrate of a first conductive type;

a first insulative layer formed on the semiconductor substrate;

a conductive layer formed on the first insulative layer in an element isolating region and applied with a constant potential;

a second insulative layer formed on a surface of the conductive layer; and

impurity regions of a second conductive type formed in a surface region of the semiconductor substrate on both sides of the conductive layer.

With the above structure, a normally-OFF parasitic MOS transistor is formed in which the conductive layer serves as a gate electrode, the first insulative layer serves as a gate insulative film and the impurity regions serve as source and drain regions. This MOS transistor functions as an element isolating region. The width of the gate electrode of the parasitic MOS transistor can be set to the narrowest value possible by the state-of-the-art fabrication process, and no bird's beaks would be formed. Since impurity regions of the second conductivity type for forming a regular semiconductor element (MOS transistor) are used as the source and drain regions, it is unnecessary to positively form the source and drain regions. This can narrower the element isolating region and can therefore provide a semiconductor IC device with higher integration. Further, given that the parasitic MOS transistor serving as the element isolating region is of N channel type and the gate is set at the ground potential, the bias of the gate oxide film of this MOS transistor is zero. As a result, reduction in threshold voltage under the atmosphere of irradiated radiation is small, so that the MOS transistor is unlikely to be turned ON by the radiation, thus preventing the otherwise possible generation of a field leak current.

The second object of this invention is achieved by a semiconductor IC device which comprises:

a semiconductor substrate of a first conductive type;

a field oxide film formed on a major surface of the semiconductor substrate;

a first insulative layer formed on the semiconductor substrate isolated by the field oxide film;

a conductive layer, formed on the field oxide film at a boundary between the first insulative layer and the field oxide film and applied with a ground potential;

a second insulative layer formed on a surface of the conductive layer; and

a semiconductor element formed in a region separated by the field oxide film in the semiconductor substrate.

With the above structure, a bias voltage can be prevented from being applied to the field oxide film under the conductive layer by means of the conductive layer applied with the ground potential. Even under the atmosphere of radiation, therefore, the parasitic MOS transistor can be prevented from being erroneously turned ON under the atmosphere of radiation. This can prevent generation of a field leak current.

This invention can be more fully understood from the following detailed description when taken in conjunction with the accompanying drawings, in which:

Fig. 1A is a plan view of a pattern of part of a semiconductor IC device according to the first embodiment of the present invention;

Fig. 1B is a cross-sectional view of the pattern in Fig. 1A taken along the line X-X';

Fig. 1C is a cross-sectional view of the pattern in Fig. 1A taken along the line Y-Y';

Fig. 2A is a plan view of a pattern of part of a semiconductor IC device according to the second embodiment of the present invention;

Fig. 2B is a cross-sectional view of the pattern in Fig. 2A taken along the line X-X';

Fig. 2C is a cross-sectional view of the pattern in Fig. 2A taken along the line Y-Y';

Fig. 3A is a plan view of a pattern of part of a semiconductor IC device according to the third embodiment of the present invention;

Fig. 3B is a cross-sectional view of the pattern in Fig. 3A taken along the line X-X'; and

Fig. 3C is a cross-sectional view of the pattern in Fig. 3A taken along the line Y-Y'.

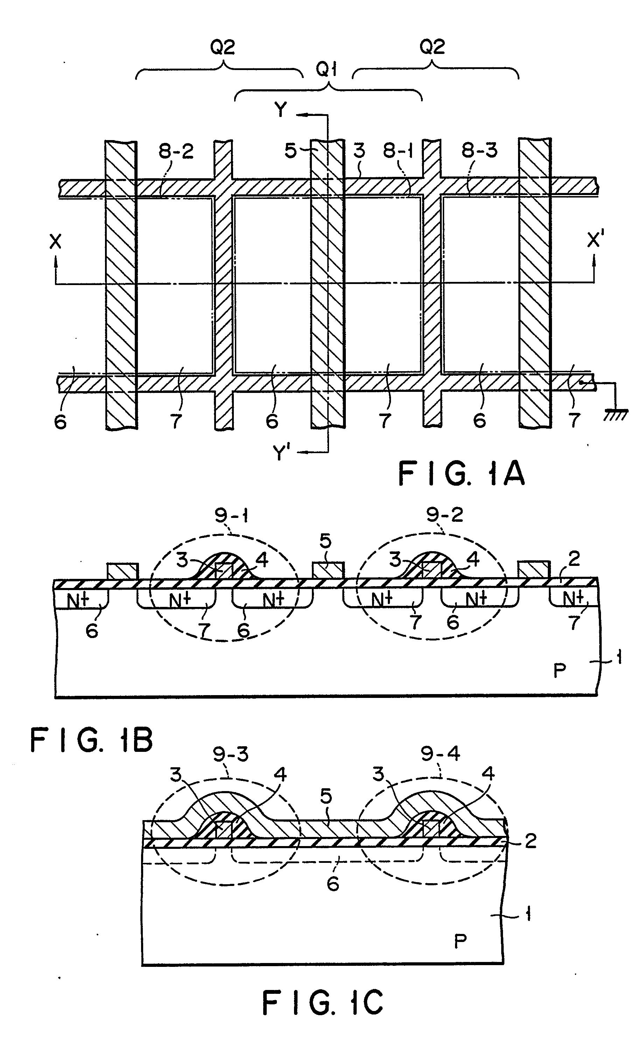

Fig. 1A is a plan view of a pattern of part of an MOS LSI according to the first embodiment of the present invention. Fig. 1B is a cross section of the pattern in Fig. 1A taken along the line X-X', and Fig. 1C is a cross section of the pattern in Fig. 1A taken along the line Y-Y'. A thin first oxide film 2 is formed on the major surface of a semiconductor substrate 1 of a P type, for example. A first polycrystalline silicon layer 3 is formed on the oxide film 2, and this layer 3 has a frame pattern so as to define an element region 8-1 (it is illustrated in Fig. 1A to be rather a grid pattern as element regions 8-2 and 8-3 adjacent to the region 8-1 are also illustrated). This polycrystalline silicon layer 3 is applied with a ground potential. A second oxide film 4 is deposited on the surface of the layer 3; the film 4 may be formed by oxidization of the surface of the layer 3. A second polycrystalline silicon layer 5, serving as a gate electrode of an MOS transistor Q1, is formed on part of the second oxide film 4 and part of the first oxide film 2. $N^+$

type impurity regions 6 and 7 serving as source and drain regions are formed in the major surface region of the semiconductor substrate 1 in the element region 8-1 separated by the first polycrystalline silicon layer 3. These impurity regions 6, 7 are formed in self-aligned manner by implanting N type impurity ions in the surface region of the semiconductor substrate 1 using the second polycrystalline silicon layer (gate electrode) 5 as a mask. MOS transistors are also formed in the element regions 8-2 and 8-3 isolated by the polycrystalline silicon layer 3, in the same manner as the MOS transistor Q1.

With the above structure, a parasitic N channel type MOS transistor Q2 is formed in regions 9-1, 9-2, 9-3 and 9-4 encircled by the broken lines in Figs. 1B and 1C. In the transistor Q2, the first polycrystalline silicon layer 3 serves as a gate electrode, the first oxide film 2 serves as a gate insulative film and the $N^+$ impurity regions 6, 7 serve as source and drain regions. Since the first polycrystalline silicon layer 3 is grounded as described above, this parasitic MOS transistor Q2 is set in a normally-off state. In other words, with the layer 3 being grounded, no inverting layer is formed in the surface region of the substrate 1 which corresponds to the channel region of the MOS transistor Q2. Accordingly, the region in which the parasitic MOS transistor Q2 is formed functions as an element isolating region to isolate those MOS transistors adjacent to the MOS transistor Q1 from one another.

With the use of such an element isolating region having the above-described structure, its width can be made narrower than that of an element isolating region which is formed using a thick filed oxide film prepared by the LOCOS method. This can contribute to higher integration of a semiconductor IC device. For instance, in case of with a semiconductor IC device fabricated with a 1-$\mu$m design rule, the field oxide film provided by the LOCOS method will be 1.9 to 2.0-$\mu$m wide and 3000 to 4000-Å thick even if the width of that portion not covered by an oxidation-resistant film (the selectively oxidized portion) is set to be 1.0 $\mu$m. In other words, the element isolating region is widened about 0.5 $\mu$m on either side by bird's beaks. In contrast to this case, as the second oxide film 4 may be formed as thin as would permit electric isolation between the polycrystalline silicon layers 3 and 5, the element isolating region is hardly widened. What is more, since the source and drain regions of the regular MOS transistor Q1 and those MOS transistors adjacent thereto can be used as the source and drain regions of the parasitic MOS transistor Q2, separate source and drain regions need not be formed. This can prevent the otherwise possible undesired widening of the element isolating region and can reduce its width to about 1/2 of the size possible by the prior art. Further, a parasitic MOS transistor having a thick field oxide film does not exist, and the gate oxide film 2 of the parasitic MOS transistor is thin but has a high resistance to irradiated radiation. Even under the atmosphere of radiation, therefore, it is possible to prevent a field leak current from flowing through the parasitic MOS transistor Q2. This enhances isolation between elements, and can provide a semiconductor IC device with high radiation-resistivity, which can function stably under the radiation atmosphere.

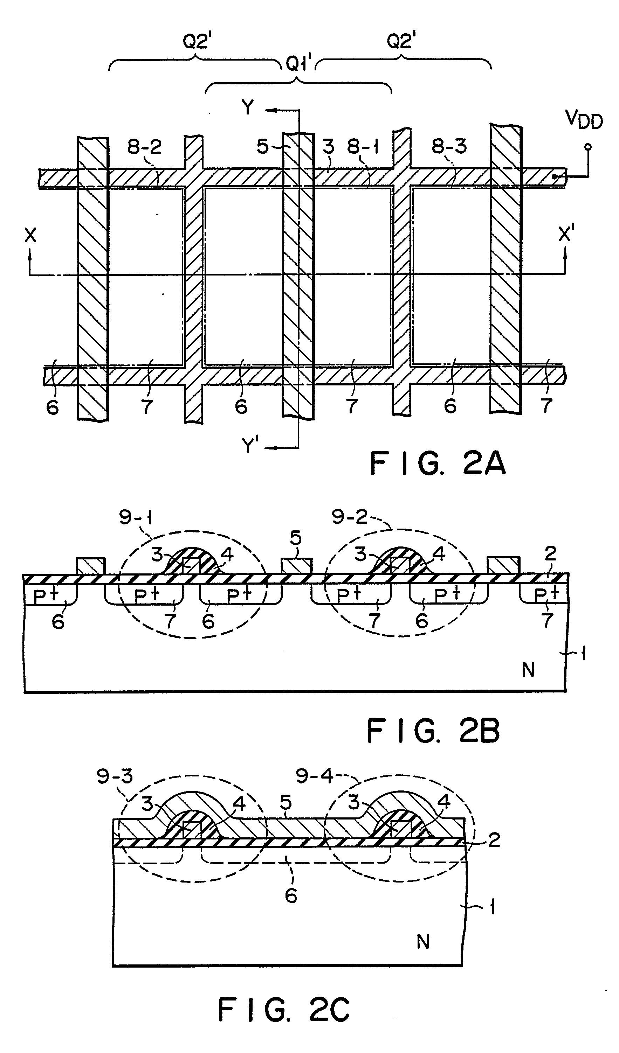

Fig. 2A is a plan view of a pattern of part of an MOS LSI according to the second embodiment of the present invention. Fig. 2B is a cross section of the pattern in Fig. 2A taken along the line X-X', and Fig. 2C is a cross section of the pattern in Fig. 2A taken along the line Y-Y'. Figs. 2A to 2C differ from Figs. 1A to 1C in the types of the source and drain regions 6, 7 and the semiconductor substrate 1 and the first polycrystalline silicon layer 3 being coupled to a source potential $V_{DD}$. That is, the semiconductor substrate 1 is of N type and $P^+$ type impurity regions are formed as the source and drain regions 6, 7. Alternatively, the semiconductor substrate 1 may be of P type and N type well regions may be formed in this substrate 1.

With the above structure, a P channel type MOS transistor Q1' is formed in the element region 8-1, and a P channel type parasitic MOS transistor Q2' around this region 8-1. Since the first polycrystalline silicon layer 3 is coupled to the power supply $V_{DD}$, this parasitic MOS transistor Q2' is set in a normally-off state, and no inverting layer is therefore formed in the substrate 1 under the polycrystalline silicon layer 3 which corresponds to the channel region of the MOS transistor Q2'. Accordingly, the region in which the parasitic MOS transistor Q2' is formed, functions as an element isolating region as per the first embodiment.

Even with the above structure, the element isolating region can be made narrower as per the first embodiment, thus realizing higher integration of a semiconductor IC device.

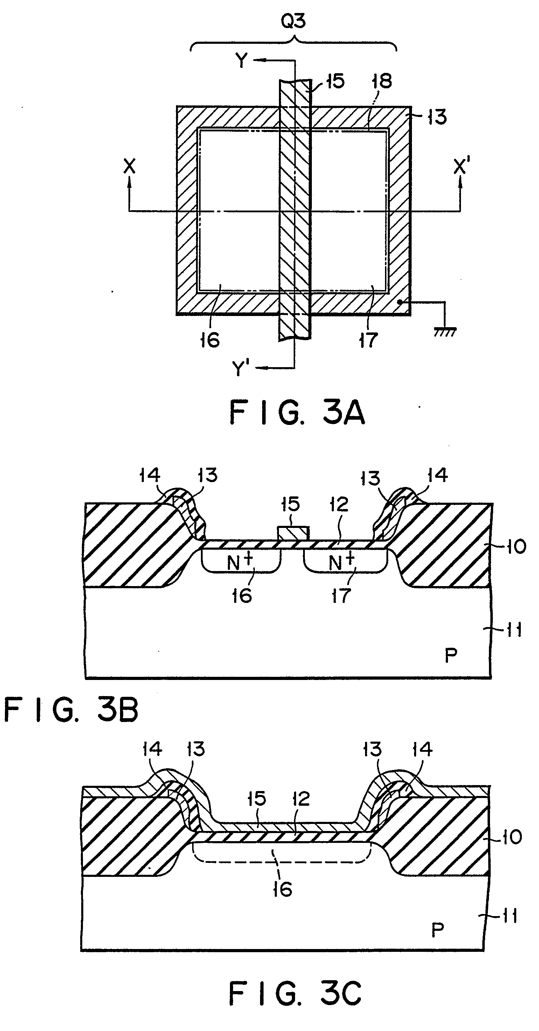

Figs. 3A to 3C illustrate the configuration of part of an MOS LSI according to the third embodiment of the present invention. Fig. 3A is a plan view of a pattern, Fig. 3B is a cross section of the pattern in Fig. 3A taken along the line X-X', and Fig. 3C is a cross section of the pattern in Fig. 3A taken along the line Y-Y'. A thick field oxide film 10 for element isolation is formed on the major surface of a semiconductor substrate 11 of, for example, a P type, by selective oxidization using the LOCOS method. An element region 18 is isolated on the substrate 11 by the field oxide film 10, and a first oxide film 12 serving as a gate insulative film is formed in the region 18. A first polycrystalline silicon layer 13 is formed on the field oxide film 10 at the boundary between this film 10 and the first oxide film 12, and it is applied with a ground potential. A second oxide film 14 is formed on the surface of the polycrystalline silicon layer 13; this film 14 is formed by, for example, oxidization of the surface of the layer 13. A second polycrystalline silicon layer 15 serving as a gate electrode of an MOS transistor Q3 is formed on part of the second oxide film 14 and part of the first oxide film 12. $N^+$ type impurity regions 16 and 17 serving as source and drain regions are formed in the major surface region of the semiconductor substrate 11 in the element region 18 isolated by the first polycrystalline silicon layer 13. These impurity regions 16, 17 are formed in self-aligned manner by implanting N type impurity ions in the surface region of the substrate 11 using the second polycrystalline silicon layer (gate electrode) 15 as a mask.

According to the above structure, the element isolating region is formed by the field oxide film 10. Provided that the semiconductor substrate 11 is set at the ground potential, since the first polycrystalline silicon layer 13 is set at the ground potential, no bias voltage would be applied to the field oxide film 10 under the layer 13, even if a wiring layer is formed on the field oxide film 10 and is applied with a voltage. Even under the radiation atmosphere, it is likely that electron and hole pairs are coupled again, thus reducing a chance of the holes being accumulated in the field oxide film 10. Therefore, no inverting layer is formed in the surface of the semiconductor substrate 11 under this film 10. Nor is it formed in the substrate 11 under the first polycrystalline silicon layer 13.

According to the structure shown in Figs. 3A to 3C, although a parasitic MOS transistor having a thick field oxide film as a gate insulative film is formed, it can be prevented from being erroneously turned on, thus preventing the otherwise possible generation of a field leak current. This can enhance the isolation between elements and can provide a semiconductor IC device with high radiation-resistivity.

As described above, according to the first and second embodiments of the present invention, a normally-off type parasitic MOS transistor is used as an element isolating region, so that the element isolating region can be formed narrower. Since no parasitic field MOS transistor having a thick field oxide film as a gate insulative film is formed, the present IC device can prevent generation of a field leak current under the atmosphere of radiation and can enhance the isolation between elements.

According to the third embodiment, even if a thick field oxide film is used for isolation of elements, the first polycrystalline silicon layer can prevent generation of a field leak current, thus making it possible to enhance the isolation between elements. Accordingly, a semiconductor IC device with high radiation-resistivity can be provided.

Reference signs in the claims are intended for better understanding and shall not limit the scope.

## Claims

1. A semiconductor IC device characterized in that in an element isolating region for electrically isolating semiconductor elements from each other, said device comprises a semiconductor substrate (1) of a first conductive type, a first insulative layer (2) formed on said semiconductor substrate (1), a conductive layer (3) formed on said first insulative layer (2) in an element isolating region and applied with a constant potential, a second insulative layer (4) formed on a surface of said conductive layer (3), and impurity regions (6, 7) of a second conductive type formed in a surface region of said semiconductor substrate (1) on both sides of said conductive layer (3); and
that a normally-OFF MOS transistor (Q2) formed with said conductive layer (3) serving as a gate electrode, said first insulative layer (2) serving as a gate insulative film and said impurity regions (6, 7) serving as source and drain regions, is used as an element isolating region.

2. A device according to claim 1, characterized in that said device further comprises a second conductive layer (5) formed on said second insulative layer (4) and said first insulative layer (2), and an MOS transistor (Q1) is formed with said second conductive layer (5) serving as a gate electrode, said first insulative layer (2) serving as a gate insulative film and said impurity regions (6, 7) serving as source and drain regions.

3. A device according to claim 1, characterized in that said conductive layer (3) includes a polycrystalline silicon layer and said second insulative layer (4) includes a silicon oxide film formed by oxidization of a surface of said polycrystalline silicon layer.

4. A semiconductor IC device characterized in that in an element isolating region for electrically isolating semiconductor elements from each other, said device comprises a semiconductor substrate (1) of a first conductive type, a first oxide film (2) formed on said semiconductor substrate (1), a first polycrystalline silicon layer (3) formed on said first oxide film (2) in an element isolating region and applied with a constant potential, a second oxide film (4) formed on a surface of said first polycrystalline silicon layer (3), a second polycrystalline silicon layer (5) formed on part of said second oxide film (4) and part of said first oxide film (2), first impurity regions (6, 7) of a second conductive type formed in a surface region of said semiconductor substrate (1) on both sides of said second polycrystalline silicon layer (5), a first MOS transistor (Q1) being formed with said first impurity regions (6, 7) serving as source and drain regions, said first oxide film (2) serving as a gate insulative film and said second polycrystalline silicon layer (5) serving as a gate electrode, a third polycrystalline silicon layer formed on part of said second oxide film (4) and part of said first oxide film (2) and isolated from said second polycrystalline silicon layer (5), and second impurity regions (6, 7) of said second conductive type formed in a surface region of said semiconductor substrate (1) on both sides of said third polycrystalline silicon layer, a second MOS transistor being formed with said second impurity regions (6, 7) serving as source and drain regions, said first oxide film (2) serving as a gate insulative film and said third polycrystalline silicon layer serving as a gate electrode; and
that a normally-OFF parasitic MOS transistor (Q2) formed with said first polycrystalline silicon layer (3) serving as a gate electrode, said first oxide film (2) serving as a gate insulative film and one of said first impurity regions (6, 7) and one of said second impurity regions (6, 7) respectively serving as source and drain regions, is used as an element isolating region to separate said first MOS transistor (Q1) from said second MOS transistor.

5. A device according to claim 1 or 4, characterized in that said first conductivity type is P type and said second conductivity type is N type, and said constant potential is a ground potential.

6. A device according to claim 1 or 4, characterized in that said first conductivity type is N type and said second conductivity type is P type, and said constant potential is a source potential ($V_{DD}$).

7. A device according to claim 4, characterized in that said second oxide film (4) includes a silicon oxide film formed by oxidization of a surface of said first polycrystalline silicon layer (3).

8. A semiconductor IC device characterized in that in an element isolating region for electrically isolating semiconductor elements from each other, said device comprises a semiconductor substrate (11) of a first conductive type, a field oxide film (10) formed on a major surface of said semiconductor substrate (11), a first insulative layer (12) formed on said semiconductor substrate (11) isolated by said field oxide film (10), a conductive layer (13), formed on said field oxide film (10) at a boundary between said first insulative layer (12) and said field oxide film (10) and applied with a ground potential, a second insulative layer (14) formed on a surface of said conductive layer (13), and a semiconductor element (Q3) formed in an element region (18) separated by said field oxide film 10) in said semiconductor substrate (11); and

that by preventing a bias voltage from being applied to said field oxide film (10) under said conductive layer (13) by means of said conductive layer (13), a parasitic field MOS transistor formed with said field oxide film (10) serving as a gate insulative film, a wiring layer formed on said field oxide film (10) serving as a gate electrode, and impurity regions (16, 17) of a second conductivity type formed in said semiconductor substrate (11) as part of said semiconductor element (Q3) serving as source and drain regions, is prevented from becoming conductive.

9. A device according to claim 8, characterized in that said semiconductor element includes an MOS transistor (Q3).

10. A device according to claim 9, characterized in that said MOS transistor (Q3) includes a polycrystalline silicon layer (15) formed on part of said second insulative layer (14) and part of said first insulative layer (12), and first and second impurity regions (16, 17) formed in said semiconductor substrate (11) at both sides of said polycrystalline silicon layer (15) in said element region (18) separated by said field oxide film (10) and serving as source and drain regions.

11. A device according to claim 8, characterized in that said second insulative layer (14) includes a silicon oxide film formed by oxidization of a surface of said conductive layer (13).

12. A semiconductor IC device characterized in that in an element isolating region for electrically isolating semiconductor elements from each other, said device comprises a semiconductor substrate (11) of a first conductive type, a field oxide film (10) formed on a major surface of said semiconductor substrate (11), a first oxide film (10) formed on said semiconductor substrate (11) isolated by said field oxide film (10), a first polycrystalline silicon layer (13), formed on said field oxide film (10) at a boundary between said first oxide film (12) and said field oxide film (10) and applied with a ground potential, a second oxide film (14) formed on a surface of said first polycrystalline silicon layer (13), a second polycrystalline silicon layer (15) formed on part of said second oxide film (14) and part of said first oxide film (12), and impurity regions (16, 17) of a second conductive type formed in a surface region of said semiconductor substrate (11) on both sides of said second polycrystalline silicon layer (15), an MOS transistor (Q3) being formed with said impurity regions (16, 17) serving as source and drain regions, said first oxide film (12) serving as a gate insulative film and said second polycrystalline silicon layer (15) serving as a gate electrode; and

that by preventing a bias voltage from being applied to said field oxide film (10) under said first polycrystalline silicon layer (13) by means of said polycrystalline silicon layer (13), a parasitic field MOS transistor formed with said field oxide film (10) serving as a gate insulative film, a wiring layer formed on said field oxide film (10) serving as a gate electrode, and one of said impurity regions (16, 17) of said second conductivity type as said source and drain regions of said MOS transistor (Q3) and one of said impurity regions (16, 17) in another element region separated by said field oxide film (10) respectively serving as source and drain regions, is prevented from becoming conductive.

13. A device according to claim 8 or 12, characterized in that said first conductivity type is P type and said second conductivity type is N type.

14. A device according to claim 12, characterized in that said second oxide film (14) includes a silicon oxide film formed by oxidization of a surface of said first polycrystalline silicon layer (13).

F I G. 1A

F I G. 1B

F I G. 1C

FIG. 2A

FIG. 2B

FIG. 2C

F I G. 3A

F I G. 3B

F I G. 3C